**Europäisches Patentamt**

**European Patent Office**

**Office européen des brevets**

(19)

(11) Veröffentlichungsnummer: **0 303 043 B1**

(12) **EUROPÄISCHE PATENTSCHRIFT**

(45) Veröffentlichungstag der Patentschrift:
20.03.91 Patentblatt 91/12

(21) Anmeldenummer: **88110668.6**

(22) Anmeldetag: **04.07.88**

(51) Int. Cl.$^5$: **B23K 1/20, B23K 35/22**

(54) **Verfahren zum flussmittelfreien Ofenlöten.**

(30) Priorität: **11.08.87 DE 3726734**

(43) Veröffentlichungstag der Anmeldung:
**15.02.89 Patentblatt 89/07**

(45) Bekanntmachung des Hinweises auf die
Patenterteilung:
**20.03.91 Patentblatt 91/12**

(84) Benannte Vertragsstaaten:
**AT BE CH DE FR GB IT LI NL SE**

(56) Entgegenhaltungen:
**EP-A- 0 004 096**

(56) Entgegenhaltungen:
**EP-A- 0 109 892**
**GB-A- 2 045 137**
**US-A- 3 832 242**
**US-A- 4 293 089**

(73) Patentinhaber: **Siemens Aktiengesellschaft**
**Wittelsbacherplatz 2**
**W-8000 München 2 (DE)**

(72) Erfinder: **Koch, Volker-Ekkehart, Dr. Dipl.-Ing.**
**Phys**
**Jägerstrasse 47**
**W-8024 Deisenhofen (DE)**
Erfinder: **Herting, Karl-Heinz, Ing.grad.**
**Wilhelm-Busch-Strasse 27**
**W-8000 München 71 (DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft ein Verfahren zum flußmittelfreien Ofenlöten, insbesondere zum Löten von Bauteilen der optischen Nachrichtentechnik, der Elektronik und der Mikromechanik auf metallischen Trägern.

Das flußmittelfreie Ofenlöten, wie es z.B. in dem Artikel "Das flußmittelfreie Ofenlöten und seine theoretischen Grundlagen" von Dipl. -Ing. R. Lison, erschienen in der Zeitschrift "Metall" 33. Jhrg., Heft 8, August 1979, S. 843 bis 848, beschrieben ist, schaltet die durch Flußmitteleinsatz auftretenden negativen Erscheinungen aus. Flußmittel haben die Aufgabe, Oxide, die meist Oberflächenschichten auf metallisierten Trägern, Bauteilen oder Lötmitteln bilden, abzulösen und nach Möglichkeit wegzuschwemmen. Die besagten Nachteile bestehen darin, daß z.B. Korrosion auftritt oder daß elektrisch leitende Schichten durch oxidische Partikel verunreinigt sind.

Die in der Regel nicht zu vermeidenden Oxidschichten werden beim flußmittelfreien Ofenlöten durch unterschiedliche Verfahrensschritte vor der eigentlichen Lötung beseitigt. Das gemeinsame Ziel aller Verfahrensschritte besteht in der Zerstörung der Metalloxide, was entweder durch Senkung des Sauerstoffpartialdruckes in der die Lötung umgebenden Atmosphäre auf einen derart niedrigen Wert geschieht, daß das Metalloxid instabil wird und sich zersetzt oder durch aktive Reduktion der Oxidschicht oder durch eine Kombination aus beidem.

Beispiele hierfür sind in dem oben genannten Artikel angeführt. Als gemeinsame Grundlage kann das Diagramm über freie Bildungsentalpien von Oxiden nach Richardson und Jeffes dienen. Das flußmittelfreie Löten unter Vakuum oder unter einem Inertgas findet unter einem derart niedrigen Sauerstoffpartialdruck statt, daß bestimmte Metall-Oxide instabil werden und zerfallen. Voraussetzung hierfür ist, daß sich der Schnittpunkt zwischen der Linie, die der konstanten Verfahrenstemperatur entspricht und der Linie die dem Sauerstoffpartialdruck entspricht, unter den entsprechenden Gleichgewichtslinien der vorliegenden Metall-Oxide befindet, also in Richtung höherer, freier Bildungentalpien liegt. Ähnliches gilt beim Einsatz einer reduzierenden Gasatmosphäre oder beim Einsatz eines gasförmig vorliegenden Elementes, welches eine höhere Affinität zum Sauerstoff besitzt, als die Metall-Oxide, die zerstört bzw. reduziert werden sollen. Als reduzierende Gase werden z.B. Wasserstoff oder Kohlenmonoxid eingesetzt oder leicht verdampfende Elemente, wie z.B. niedrig verdampfende Metalle oder Phosphor, die ebenfalls als Reduktionsmittel eingesetzt werden können.

Werden Metalldämpfe als Reduktionsmittel eingesetzt, so besteht ein großer Nachteil darin, daß sich die Metalloxide des oxidierten Reduktionsmittels z.B. auf den Oberflächen der Bauteile niederschlagen.

Wird ein Vakuum zur Reduktion der unerwünschten Metall-Oxide eingesetzt, so ist es in Abhängigkeit vom vorliegenden Metall-Oxid meist erforderlich ein relativ hohes Vakuum anzulegen.

Bei der Verwendung einer Inertgasatmosphäre wird höchste Reinheit des Inertgases gefordert, um ein im festen Zustand vorliegendes Oxid zum Zerfall zu bringen, da indirekt auch hier mit niedrigem Sauerstoffpartialdruck gearbeitet wird. Die beim flußmittelfreien Ofenlöten üblicherweise verwendeten Lötmittel liegen als Lotformteile vor und sind beim Löten von kleineren Bauteilen äußerst schwer zu handhaben. Als Alternative würde sich nur die Verwendung von Lotpasten anbieten, die wiederum Flußmittel enthalten.

Durch die US-A-3832242 ist ein Verfahren bekannt, wobei als Lötmittel eine aus Metallpulver und Bindemittel hergestellte Paste verwendet wird, und wobei :

- Träger, Paste und Bauteil übereinander angeordnet und positioniert werden,
- die Anordnung unter Einsatz von einer Inertgas- und/oder Reduktionsgasatmosphäre auf Löttemperatur erhitzt wird.

Der Erfindung liegt die Aufgabe zugrunde, ein Verfahren zum flußmittelfreien Ofenlöten anzubieten, wobei Binde- oder Lösungsmittel vor dem eigentlichen Lötprozeß entfernt werden und vorhandene Oxide auf Metalloberflächen einfach und wirkungsvoll beseitigt werden.

Diese Aufgabe wird erfindungsgemäß durch die folgenden Merkmale gelöst :

- als Lötmittel wird eine Paste, hergestellt aus Metallpulver und Bindemittel, verwendet,
- Träger, Paste und Bauteil werden übereinander angeordnet und positioniert,
- das Bindemittel wird durch Anlegen eines Vakuums aus der Paste zumindest weitgehend entfernt,
- die Anordnung aus Träger, Paste und Bauteil wird von einer Inertgas- und/oder Reduktionsgasatmosphäre umgeben oder umspült,
- die Anordnung wird unter Beibehaltung der Inertgas- und/oder Reduktionsgasatmosphäre auf Löttemperatur erhitzt.

Die Flußmittelfreiheit ist bei Lötprozessen, die Teile der Mikromechanik, wie z.B. einen Piezoplanarkopf, auf metallischen Trägern befestigen, Voraussetzung für eine qualitativ hochwertige Verbindung. Der Übergang von einem Verfahren, das Lotformteile verwendet zu einem Verfahren, welches mit einer flußmittelfreien Paste arbeitet, bringt bezüglich der Handhabung des Lötmittels besondere Vorteile mit sich. Es ist weder nötig eine Lötmittelschicht auf Bauteil oder Träger aufzudampfen, noch irgendeine Umschmelzung vorzunehmen. Die Paste, die aus Metallpulver und aus möglichst leichtflüchtigem Bindemittel hergestellt ist, kann in einer Zentrifuge vergleichmäßigt werden und wird z.B. durch ein Tampoprintverfahren auf einen Träger oder auf ein Bauteil aufgebracht, wobei die Menge gut dosierbar ist. Dies gilt insbesondere für Bauteile aus der Mikromechanik, wozu Bauteile gezählt werden, deren Querschnittsfläche z.B. kleiner, als ein Quadratmillimeter ist. Das Bindemittel, das lediglich zur Handhabung der Paste dient, erzeugt eine geringfügige Klebewirkung um die Paste selbst auf der Oberfläche festzuhalten. Mittels verschiedener Mischungsverhältnisse zwischen Metallpulver und Bindemittel läßt sich eine gewünschte Konsistenz der Paste einstellen. Die Bauteile werden in der Regel durch eine Apparatur auf der Paste und dem Träger in ihrer Position fixiert. Die gesamte Anordnung befindet sich in einer Kammer oder in einem Ofen, wobei als nächster Schritt ein Vakuum, was z.B. an den Lötofen angelegt wird, für eine zumindest weitgehende Entfernung des Bindemittels aus der Paste sorgt. Die Kombination aus der Verwendung einer Paste, dem Austreiben des Bindemittels durch ein Vakuum und der nun folgenden Lötung unter Inert- und/oder Reduktionsgasatmosphäre, ergibt nicht nur Vorteile in der Handhabung, sondern hat auch den Vorteil, daß geringfügige Verunreinigungen in der Paste, auf dem Bauteil oder auf dem Träger keinen störenden Einfluß haben, was beim Löten mit einem Flußmittel durch die aufgeschwemmte Oxidpartikel sehr wohl der Fall wäre. Die Beseitigung von oberflächlichen Metall-Oxidschichten wird hier jedoch, wie schon erwähnt, nicht durch ein Flußmittel, sondern durch eine Inertgas- und/oder Reduktionsgasatmosphäre bewerkstelligt.

Eine besonders vorteilhafte Ausgestaltung der Erfindung sieht vor, daß als Bindemittel ein Alkohol verwendet wird. Hier sind insbesondere Methyl- oder Äthylalkohol vorteilhaft, deren Siedepunkte bei Normaldruck bei ca. 60 bis 80°C liegen, die also als relativ leichtflüchtig angesehen werden können und somit die Möglichkeit besteht, sie mittels Vakuum vollständig aus der Paste zu entfernen.

Das anzulegende Vakuum um das Bindemittel zu entfernen sollte mindestens 0,5 mbar betragen.

Die Apparatur, mit der Bauteilpaste und Träger in ihrer gegenseitigen Position fixiert werden, kann in einer Ausgestaltung der Erfindung in Form eines Niederhalters ausgeführt sein. Dies kann ein federnd aufgehängter Hebelarm, ein selbstfedernder Hebel oder z.B. eine Blattfeder sein.

Das erfindungsgemäße Verfahren kann mittels einer Inertgasatmophäre durchgeführt werden, wenn z.B. die Metall-Oxidschichten nicht vollständig oder unterbrochen sind. Als vorteilhafte Ausgestaltung der Erfindung wird der Einsatz einer Reduktionsgasat-mosphäre vorgesehen. Diese Reduktionsgasatmos-phäre beseitigt aktiv die auf den metallischen Oberflächen vorliegenden Metall-Oxidschichten.

Dazu ist es vorteilhaft, wenn das Reduktionsgas nach seiner Oxidation ebenfalls gasförmig mit möglichst niedrigem Taupunkt vorliegt. Hier hat Kohlenmonoxid, das nach einer Oxidation als Kohlendioxid vorliegt, wesentliche Vorteile gegenüber einem Reduktionsgas, bestehend aus einem dampfförmigen Metall.

Der Einsatz von Wasserstoff als Reduktionsgas hat gegenüber dem Einsatz von Kohlenmonoxid den Vorteil, daß bei gleichen Verhältnissen der Wasserstoff das größere Reduktionspotential besitzt.

Anhand eines Ausführungsbeispiels wird im fol-genden das erfindungsgemäße Verfahren schema-tisch dargestellt.

Fig. 1 zeigt eine Anordnung, bestehend aus Träger T, Paste P, Bauteil B und einem Niederhalter N.

Fig. 2 zeigt den schematischen Verfahrensablauf.

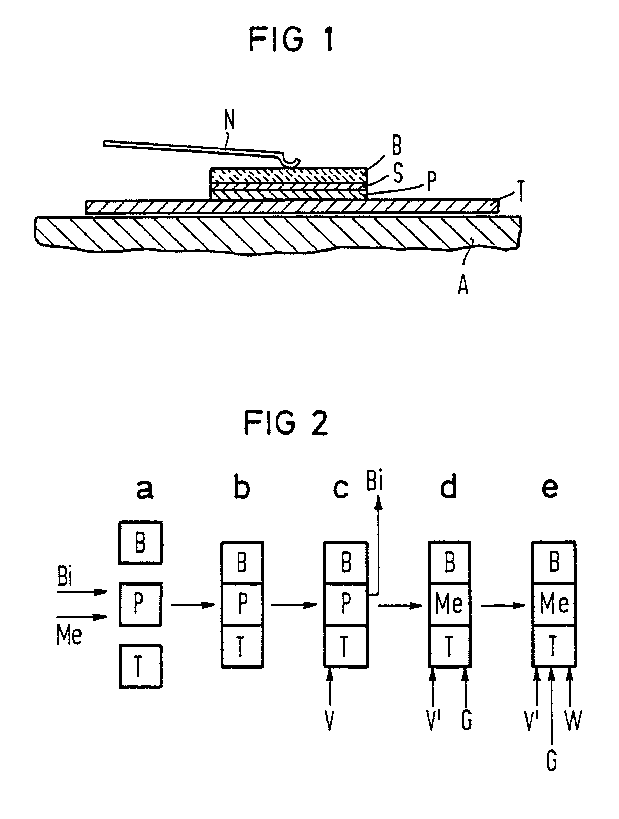

Die in Fig. 1 dargestellte Anordnung wird auf einer Auflage A plaziert. Die Paste P wird in genauer Dosierung durch ein z.B. Tampoprintverfahren auf den Träger T aufgebracht und ein Bauteil B, das mit einer meist aufgedampften Metallschicht S versehen ist, wird auf der Paste positioniert und mittels des Niederhalters N fixiert. Die Metallschicht S besteht in der Regel aus dem gleichen Metall, wie der Träger T. Hierzu werden in der Mikromechanik bevorzugt Nickelschichten bzw. Nickelfolien eingesetzt. Die Verwendung von anderen lötbaren und gut gleitfähigen Metallen, wie z.B. von Kupfer, ist auch möglich.

Als ein Teil aus der Mikromechanik kann z.B. ein Piezosensor, speziell ein Piezoplanarkopf, angesehen werden. Seine Querschnittsfläche beträgt ca. 1 $mm^2$ oder weniger und kann rund, oval oder z.B. sechseckig sein. Die Höhe beträgt etwa 30 μm und die Lot-schichtdicke liegt zwischen 10 und 15 μm. Zur Durchführung kommt eine Weichlötung, deren Verfahrenstemperatur bis maximal 500°C reicht, die die Metallschicht S des Bauteiles B, bestehend aus Nickel, auf den Träger T, bestehend aus einer Nickelfolie, mittels eines handelsüblichen Blei-Zinn-Lotes, in diesem Fall ein bleireiches Lot, verbindet. Zur Herstellung der Paste wird das Blei-Zinn-Lot mit Äthylalkohol als Bindemittels angerührt. Die Metall-Oxidschicht auf den Nickeloberflächen, die unabhängig von der Zeit der Oxidation eine Dicke von ca. 100 bis 150 × $10^{-7}$ mm hat, sowie das teilweise oxidierte Lötmittel werden durch den Einsatz einer Wasserstoffatmosphäre reduziert. Der Zeitpunkt des Lotflußes beim Erwärmen auf Löttemperatur bzw. die zu dem Zeitpunkt anliegende Verfahrenstemperatur signalisieren, daß die Oxidschichten vollständig beseitigt sind. Der Beginn des Lotflußes, der mit einer Benetzung der Metalloberflächen einhergeht, ist eindeutiger Indikator dafür. Der Lotfluß beginnt beim Einsatz von Nickel bei etwa 350 bis 370°C und beim Einsatz von Kupfer bei ca. 270°C.

In Fig. 2 sind die Verfahrensschritte a-e aufgeführt, wobei im einzelnen folgendes geschieht :

a) Es liegen das Bauteil B und der Träger T vor, sowie die Paste P, die aus dem Bindemittel Bi und dem Metallpulver Me hergestellt wurde.

b) Bauteil B, Paste P und Träger T werden übereinander angeordnet und positioniert. Falls die durch den verwendeten Äthylalkohol bewirkte verstärkte Athäsion der Paste ausreicht, das Bauteil an seinem Platz zu halten, kann auf ein Niederhalter N verzichtet werden.

c) Durch Anlegen eines Vakuums V wird das Bindemittel Bi aus der Paste weitestgehend entfernt, wobei das Metallpulver Me übrig bleibt.

d) Die Anordnung wird von einer Gasatmosphäre G, in diesem Fall einer Reduktionsgasatmosphäre aus Wasserstoff, umgeben oder umspült, wobei ein Vakuum V' im Ofen bestehen bleibt. Dieses Vakuum V' wird zur Sicherheit beibehalten, um eventuell Sauerstoffeinbrüche abfangen zu können. Das Vakuum V' beträgt ca. 500 mbar.

e) Die Anordnung wird unter Beibehaltung des Vakuums V' und der Gasatmosphäre G durch die Zufuhr von Wärme W auf Löttemperatur erhitzt.

Dieses Verfahren nützt zum einen die Vorteile des flußmittelfreien Ofenlötens aus, so daß zu keiner Zeit durch Flußmittel aufgeschwemmte Metall-Oxidteilchen die Qualität der Lötung bezüglich Korosion oder elektrischer Leitung beeinträchtigt wird. Genauso wenig können sich verdampfte Flußmittel aus der Gasphase auf Teilen der Oberfläche der Anordnung niederschlagen. Als Reduktionsgas wird Wasserstoff eingesetzt, wobei auch wieder verhindert wird, daß sich das oxidierte Reduktionsmittel auf der Anordnung oder im Ofen durch Kondensation niederschlägt, wie es z.B. bei Verwendung eines gasförmig vorliegenden Metalles als Reduktionsmittel der Fall wäre. Die schwierige Handhabung von Lotformteilen mit den Größenordnungen, wie sie beschrieben wurden, ist nicht notwendig. Der Einsatz eines Metallpulvers ME, im speziellen der eines Blei-Zinn-Lotes, ist in einfacher Weise dadurch zu bewerkstelligen, daß das Metallpulver zeitweise mit einem Bindemittel Bi zur Paste P vermischt wird und das Metallpulver in Anschluß an die Entfernung des Bindemittels Bi aus der Paste P in reiner Form vorliegt.

## Ansprüche

1. Verfahren zum flußmittelfreien Ofenlöten, insbesondere zum Löten von Bauteilen (B) der optischen Nachrichtentechnik, der Elektronik und der Mikromechanik auf metallischen Trägern (T), wobei als Lötmittel eine aus Metallpulver (Me) und Bindemittel (Bi) hergestellte Paste (P) verwendet wird, und das die folgendem Schritte umfaßt :
   – Träger (T), Paste (P) und Bauteil (B) übereinander angeordnet und positioniert werden,
   – das Bindemittel (Bi) durch Anlegen eines Vakuums (V) aus der Paste (P) zumindest weitgehend entfernt wird,
   – die Anordnung aus Träger (T), Paste (P) und Bauteil (B) von einer Inertgas- und/oder Reduktionsgasatmosphäre (G) umgeben oder umspült wird und
   – die Anordnung unter Beibehaltung der Inertgas- und/oder Reduktionsgasatmosphäre (G) auf Löttemperatur erhitzt wird.

2. Verfahren nach Anspruch 1, **dadurch gekennzeichnet**, daß als Bindemittel (Bi) ein Alkohol verwendet wird.

3. Verfahren nach Anspruch 2, **dadurch gekennzeichnet**, daß als Bindemittel (Bi) Methyl- oder Äthylalkohol verwendet wird.

4. Verfahren nach einem der vorhergehenden Ansprüche, **dadurch gekennzeichnet**, daß das Bindemittel (Bi) im Vakuum (V) vollständig aus der Paste entfernt wird.

5. Verfahren nach einem der vorhergehenden Ansprüche, **dadurch gekennzeichnet**, daß zum Entfernen des Bindemittels (Bi) ein Vakuum (V) von mindestens 0,5 mbar angelegt wird.

6. Verfahren nach einem der vorhergehenden Ansprüche, **dadurch gekennzeichnet**, däß die Anordnung von Träger (T), Paste (P) und Bindemittel (Bi) mittels eines Niederhalters (N) festgehalten wird.

7. Verfahren nach einem der vorhergehenden Ansprüche, **dadurch gekennzeichnet**, daß eine Reduktionsgasatmosphäre (G) eingesetzt wird.

8. Verfahren nach Anspruch 7, **dadurch gekennzeichnet**, daß zur Erzeugung einer reduzierenden Atmosphäre CO-Gas verwendet wird.

9. Verfahren nach Anspruch 7, **dadurch gekennzeichnet**, daß zur Erzeugung einer reduzierenden Atmosphäre Wasserstoff verwendet wird.

## Claims

1. Method for fluxless oven soldering, preferably for soldering components (B) in optical communications engineering, electronics and micromechanics to metallic substrates (T), a paste (P) produced from metal powder (Me) and binding agent (Bi) being used as soldering agent, and which comprises the following steps :
   – substrate (T), paste (P) and component (B) are arranged and positioned one above the other,
   – the binding agent (Bi) is at least largely removed from the paste (P) by applying a vacuum (V),
   – an inert-gas and/or reducing-gas atmosphere (G) surrounds or flows around the arrangement of substrate (T), paste (P) and component (B), and
   – the arrangement is heated to soldering temperature while maintaining the inert-gas and/or reducing-gas atmosphere (G).

2. Method according to Claim 1, characterised in that an alcohol is used as binding agent (Bi).

3. Method according to Claim 2, characterised in that methyl or ethyl alcohol is used as binding agent (Bi).

4. Method according to one of the preceding claims, characterised in that the binding agent (Bi) is completely removed from the paste in the vacuum (V).

5. Method according to one of the preceding claims, characterised in that, to remove the binding agent (Bi), a vacuum (V) of at least 0.5 mbar is applied.

6. Method according to one of the preceding claims, characterised in that the arrangement of substrate (T), paste (P) and binding agent (Bi) is held in place by means of a holding-down device (N).

7. Method according to one of the preceding claims, characterised in that a reducing-gas atmosphere (G) is used.

8. Method according to Claim 7, characterised in that CO-gas is used to produce a reducing atmosphere.

9. Method according to Claim 7, characterised in that hydrogen is used to produce a reducing atmosphere.

**Revendications**

1. Procédé de soudage au four sans utilisation de flux, notamment pour souder des composants (B) utilisés dans la technique des communications par voie optique, en électronique et en micromécanique, sur des supports (T) métalliques, qui consiste à utiliser comme agent de soudure une pâte (P) préparée à partir d'une poudre métallique (Me) et d'agent liant (Bi) et qui comprend les stades suivants :
    – on dispose et l'on place les uns au-dessus des autres le support (T), la pâte (P) et le composant (B),
    – on élimine, au moins dans une grande mesure, l'agent liant (Bi) de la pâte (P) par application d'un vide (V),
    – on met le dispositif constitué du support (T), de la pâte (P) et du composant (B) sous une atmosphère (G) de gaz inerte et/ou de gaz réducteur ou on fait passer cette atmosphère sur le dispositif et
    – on porte le dispositif à la température de soudage, tout en maintenant l'atmosphère (G) de gaz inerte et/ou de gaz reducteur.

2. Procédé suivant la revendication 1, caractérisé
en ce qu'il consiste à utiliser un alcool comme agent liant (Bi).

3. Procédé suivant la revendication 2, caractérisé
en ce qu'il consiste à utiliser de l'alcool méthylique ou de l'alcool éthylique comme agent liant (Bi).

4. Procédé suivant l'une des revendications précédentes, caractérisé
en ce qu'il consiste à éliminer sous le vide (B) complètement l'agent liant (Bi) de la pâte.

5. Procédé suivant l'une des revendications précédentes, caractérisé
en ce qu'il consiste à appliquer un vide (V) d'au moins 0,5 millibar pour éliminer l'agent liant (Bi).

6. Procédé suivant selon l'une des revendications précédentes, caractérisé
en ce qu'il consiste à maintenir le dispositif constitué du support (T), de la pâte (P) et de l'agent liant (Bi) au moyen d'un serre-flanc (N).

7. Procédé suivant l'une des revendications précédentes, caractérisé
en ce qu'il consiste à mettre en oeuvre une atmosphère (G) de gaz réducteur.

8. Procédé suivant la revendication 7, caractérisé
en ce qu'il consiste à utiliser du CO gazeux pour produire une atmosphère réductrice.

9. Procédé selon la revendication 7, caractérisé
en ce qu'il consiste à utiliser de l'hydrogène pour produire une atmosphère réductrice.

# FIG 1

# FIG 2